# FASCICULE DE BREVET EUROPEEN

(11) **EP 3 069 506 B1**
(45) Date de publication et mention de la délivrance du brevet: **29.07.2020**
(21) Numéro de dépôt: 14798745.7
(22) Date de dépôt: 05.11.2014
(51) Int. Cl.: H04N 5/378, H01L 27/146

(54) **MISE EN COMMUN DE DEUX COLONNES DE PIXELS D'UN DETECTEUR D'IMAGES**
POOLING VON ZWEI PIXELSPALTEN EINES BILDDETEKTORS
POOLING OF TWO COLUMNS OF PIXELS OF AN IMAGE DETECTOR

(30) Priorité: 15.11.2013 FR 1361186
(43) Date de publication de la demande: 21.09.2016
(73) Titulaire: Trixell, 38430 Moirans (FR)
(72) Inventeur: WIRTH, Thibaut, 38430 Moirans (FR); BOSSET, Bruno, 38430 Moirans (FR); MARECAUX, Simon, 38430 Moirans (FR); VENIN, Claude, 38430 Moirans (FR); ROHR, Pierre, 38430 Moirans (FR)
(74) Mandataire: Collet, Alain
(86) Numéro de dépôt international: PCT/EP2014/073764
(87) Numéro de publication internationale: WO 2015/071140

(56) Documents cités:
- EP-A2- 2 549 299
- WO-A1-95/17767
- US-A1- 2005 104 089
- US-A1- 2006 023 109
- US-A1- 2008 042 046
- US-A1- 2010 091 150
- US-A1- 2011 254 988
- US-A1- 2012 119 065
- US-A1- 2012 286 138
- US-A1- 2013 092 820

## Description

L'invention concerne un dispositif d'imagerie. L'invention peut être mise en œuvre pour la prise d'image dans un détecteur. Ce type de dispositif comprend un grand nombre de points sensibles appelés pixels généralement organisés en matrice ou en barrette.

L'invention trouve une utilité dans la réalisation d'images visibles mais n'est pas limitée à ce domaine. Dans le cadre de l'invention, le terme imagerie doit s'entendre dans un sens large. On peut par exemple réaliser des cartographies de pression ou de température ou encore des représentations en deux dimensions de potentiels chimiques ou électriques. Ces cartographies ou représentations forment des images de grandeurs physiques.

Dans un détecteur, un pixel représente l'élément sensible élémentaire du détecteur. Chaque pixel convertit un phénomène physique auquel il est soumis en un signal électrique. Les signaux électriques issus des différents pixels sont collectés lors d'une phase de lecture de la matrice puis numérisés de manière à pouvoir être traités et stockés pour former une image. Les pixels sont formés d'une zone sensible au phénomène physique et délivrant un courant de charges électriques. Le phénomène physique peut être un rayonnement électromagnétique et par la suite, l'invention sera expliquée au moyen de ce type de rayonnement et le courant de charge est fonction du flux de photons reçu par la zone sensible. La généralisation à tout dispositif d'imagerie sera aisée.

La zone photosensible comprend généralement un élément photosensible, ou photodétecteur, qui peut par exemple être une photodiode, deux diodes tête-bèche, une photorésistance ou un phototransistor. On trouve des matrices photosensibles de grandes dimensions qui peuvent posséder plusieurs millions de pixels. Chaque pixel est constitué d'un élément photosensible et d'un circuit électronique constitué par exemple d'interrupteurs, capacités, résistances, en aval duquel est placé un actionneur. L'ensemble constitué par l'élément photosensible et le circuit électronique permet de générer des charges électriques et de les collecter. Le circuit électronique permet généralement la réinitialisation de la charge collectée dans chaque pixel après un transfert de charge. Le rôle de l'actionneur est de transférer ou recopier les charges collectées par le circuit dans un conducteur de colonne. Ce transfert est réalisé lorsque l'actionneur en reçoit l'instruction. La sortie de l'actionneur correspond à la sortie du pixel.

Dans ce type de détecteur, un pixel fonctionne selon deux phases : une phase de prise d'image, durant laquelle le circuit électronique du pixel accumule les charges électriques générées par l'élément photosensible, et une phase de lecture, au cours de laquelle les charges collectées sont transférées ou recopiées dans le conducteur de colonne, grâce à l'actionneur.

Lors de la phase de prise d'image, l'actionneur est passif et les charges électriques collectées font évoluer le potentiel en un point de connexion entre l'élément photosensible et l'actionneur. Ce point de connexion est appelé nœud de collecte des charges du pixel ou plus simplement nœud du pixel. Lors de la phase de lecture, l'actionneur est actif afin de libérer les charges accumulées au niveau du point photosensible afin de les acheminer ou de les recopier, voire de recopier le potentiel du nœud du pixel vers un circuit de lecture du détecteur disposé en aval de l'actionneur.

Par actionneur passif, on entend un actionneur n'étant pas en contact électrique avec le circuit de lecture. Ainsi, lorsque l'actionneur est passif, les charges collectées dans le pixel ne sont ni transférées, ni recopiées dans le circuit de lecture.

Un actionneur peut être un interrupteur commandé par un signal d'horloge. Il s'agit généralement d'un transistor. Il peut également s'agir d'un circuit suiveur ou de tout autre dispositif permettant de reporter ou transférer la charge collectée dans le pixel vers le circuit de lecture, par exemple un dispositif connu sous l'acronyme anglo-saxon : CTIA (« Capacitive Translmpedance Amplifier » pour amplificateur de transfert d'impédance capacitive).

Ce type de pixel peut être utilisé pour l'imagerie de rayonnements ionisants, et notamment les détecteurs de rayonnements X ou y, dans le domaine médical ou celui du contrôle non destructif dans le domaine industriel, pour la détection d'images radiologiques. Dans certains détecteurs, les éléments photosensibles permettent de détecter un rayonnement électromagnétique visible ou proche du visible. Ces éléments ne sont pas, ou peu, sensibles au rayonnement incident au détecteur que l'on souhaite détecter. On utilise alors un convertisseur de rayonnement appelé scintillateur qui convertit le rayonnement incident, par exemple un rayonnement X, en un rayonnement dans une bande de longueurs d'onde auxquelles sont sensibles les éléments photosensibles présents dans les pixels.

Selon un autre type de détecteur, de plus en plus répandu, le matériau détecteur est un semi-conducteur, sensible au rayonnement, par exemple X ou γ, à détecter. Une interaction d'un rayonnement dans le détecteur génère des porteurs de charges. On collecte les charges générées par une interaction à une borne, appelée nœud du pixel.

Lors de la phase de prise d'image, le rayonnement électromagnétique, sous forme de photons reçus par chaque élément photosensible, est converti en charges électriques (paires électrons/trous) et chaque pixel comprend généralement une capacité permettant d'accumuler ces charges pour faire évoluer la tension du nœud du pixel. Cette capacité peut être intrinsèque à l'élément photosensible, on parle alors de capacité parasite, ou ajoutée sous forme d'un condensateur connecté en parallèle de l'élément photosensible.

Généralement, les pixels sont lus individuellement. La matrice peut par exemple comprendre un conducteur de colonne associé à chaque colonne de pixels de la matrice. Dans ce cas, une instruction de lecture est émise vers tous les actionneurs d'une même ligne de la matrice et chacun des pixels de cette ligne est lu en transférant son information électrique, charge, tension, courant, fréquence... au conducteur de colonne auquel il est associé.

On peut être amené à regrouper plusieurs pixels pour les lire collectivement. Ce regroupement peut être utile afin d'augmenter la vitesse de lecture de la matrice ou encore pour améliorer le rapport signal sur bruit de chaque élément lu. Les pixels groupés peuvent disposer de moyens pour réaliser les opérations de somme ou de moyenne des informations électriques des pixels regroupés. Ces moyens peuvent être analogiques ou numériques.

Par la suite, on décrira le cas où l'information électrique est disponible de façon analogique dans les pixels, sous forme de quantités de charges stockées sur des condensateurs de même valeur. Il est bien entendu que l'invention peut être mise en œuvre pour toute forme d'information électrique générée dans chacun des pixels.

Un détecteur d'images comprend en général un capteur d'images. Le capteur d'images comporte des conducteurs de ligne, chacun reliant les pixels d'une même ligne, et des conducteurs de colonnes, chacun reliant les pixels d'une même colonne. Les conducteurs de colonnes sont connectés à un circuit de lecture, également appelé bloc de lecture de colonnes.

Le document US 2008/042046 A1 décrit un dispositif de détection de quantité physique comprenant au moins deux substrats semi-conducteurs empilés échangeant un signal lu à partir d'une matrice de pixels. Chaque substrat comprend une pluralité de plots de contact connectés en parallèle et disposés selon les colonnes de la matrice de pixels, et destinés à transmettre le signal d'un substrat à l'autre. Un multiplexeur connecte deux colonnes pour les faire converger vers un plot de contact sur le même substrat.

Le document US 2011/254988 A1 décrit un détecteur d'images comprenant un capteur avec une matrice de pixels, un élément périphérique de contrôle et traitement de l'image relié au capteur et empilés entre eux. Un sélecteur peut associer plusieurs colonnes de la matrice à un plot de contact.

La connexion entre le bloc de lecture de colonnes et un conducteur de colonne se fait au niveau d'un plot de contact. Il y a donc, dans la configuration traditionnelle d'un détecteur d'images, autant de plots de contact que de conducteurs de colonnes et donc que de colonnes de pixels. On définit un écartement entre deux conducteurs de colonnes. L'écartement entre deux conducteurs de colonnes correspond à l'écartement entre deux plots de contact. Pour certaines applications, on souhaite réduire l'écartement entre deux conducteurs de colonnes tout en maintenant un écartement plus important entre deux plots de contact. C'est le cas notamment dans le domaine de l'imagerie médicale par rayons X et plus particulièrement pour une application à la mammographie où des images de haute qualité sont requises. Le pixel peut occuper une surface carrée de l'ordre de 50 micromètres (µm) de côté, c'est-à-dire inférieure aux tailles usuelles de pixels utilisés en radiologie X standard. L'écartement entre les plots de contact est alors réduit. La connexion des plots de contact avec le bloc de lecture de colonnes est réalisée au moyen de modules de connectique. Or, les modules de connectique ne sont pas forcément adaptés pour de petits écartements entre deux plots de contact.

L'invention vise à réduire l'écartement entre deux conducteurs de colonnes tout en maintenant un écartement plus important entre deux plots de contact en proposant une mise en commun de deux colonnes de pixels d'un détecteur d'images.

A cet effet, l'invention a pour objet un détecteur d'images comprenant :
- un capteur réalisé sur un premier substrat monolithique comprenant :
   ∘ un ensemble de pixels organisé en matrice selon des lignes et des colonnes et configuré de façon à générer des signaux en fonction d'un rayonnement frappant le détecteur,
   ∘ des conducteurs de colonne, chacun reliant les pixels d'une même colonne et destinés à transporter les signaux générés par les pixels,
   ∘ au moins un plot de contact situé à la périphérie du premier substrat et en dehors de la matrice de pixels et relié aux conducteurs de colonne,
   au moins deux conducteurs de colonnes connectés ensemble sur le premier substrat en dehors de la matrice de pixels et les conducteurs de colonne connectés ensemble convergent vers le au moins un plot de contact, le détecteur d'images comprend des conducteurs de lignes, chacun reliant les pixels une même ligne, et un bloc d'adressage de lignes et relié aux conducteurs de lignes, le détecteur d'images comprenant en outre au moins un conducteur de lignes additionnel par ligne, les conducteurs de lignes étant connectés aux colonnes de rang impair, le au moins un conducteur de lignes additionnel étant connecté aux colonnes de rang pair, permettant de lire individuellement chaque pixel (P(i,j)).

L'invention sera mieux comprise et d'autres avantages apparaîtront à la lecture de la description détaillée d'un mode de réalisation donné à titre d'exemple, description illustrée par le dessin joint dans lequel :
- les figures 1a et 1b représentent un détecteur d'images traditionnel ;
- les figures 2a et 2b représentent une configuration de détecteur d'images selon l'invention ;
- la figure 3 représente une deuxième configuration de détecteur d'images selon un exemple ;
- la figure 4 représente une troisième configuration de détecteur d'images selon un exemple ;
- la figure 5 représente une quatrième configuration de détecteur d'images selon un exemple ;
- la figure 6 représente une cinquième configuration de détecteur d'images selon un exemple ;
- la figure 7 représente une sixième configuration de détecteur d'images selon un exemple ;
- la figure 8 représente le détecteur d'images selon l'invention, avec un capteur comprenant trois zones distinctes.

Par souci de clarté, les mêmes éléments porteront les mêmes repères dans les différentes figures.

De manière générale, l'invention concerne un détecteur d'images comprenant un capteur comprenant un ensemble de pixels organisé en matrice selon des lignes et des colonnes, des blocs d'adressage de lignes, des blocs de lecture de colonnes, des conducteurs de ligne reliant les lignes de pixels à un bloc d'adressage de lignes, et des conducteurs de colonne reliant les colonnes de pixels à un bloc de lecture de colonnes. Il est à noter que, dans le cadre de la présente demande de brevet, les notions de colonne et de ligne n'ont qu'un sens relatif, une ligne de pixels et une colonne de pixels n'étant autres que des rangées de pixels disposées par exemple perpendiculairement l'une à l'autre. Un conducteur de ligne, respectivement de colonne, est défini comme étant orienté parallèlement à une ligne de pixels, respectivement une colonne de pixels.

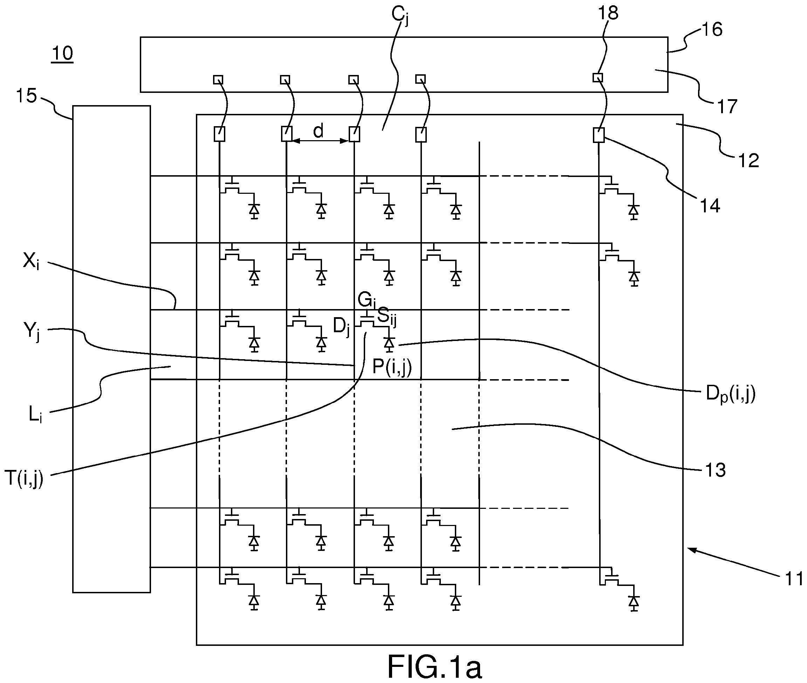

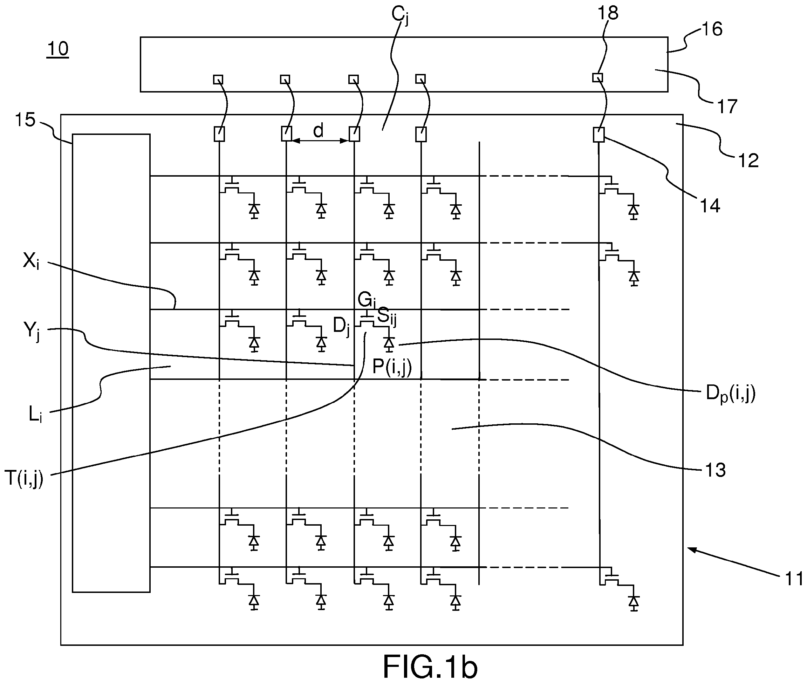

La figure 1a représente un détecteur d'images 10 traditionnel. Le détecteur d'images 10 comprend un capteur 11 réalisé sur un premier substrat monolithique 12. Le premier substrat monolithique 12 comprend un ensemble de pixels P(i,j) organisé en matrice 13 selon des lignes Li et des colonnes Cj. La matrice 13 peut comporter un nombre quelconque de lignes et de colonnes formant ainsi des pixels P(i,j). La matrice 13 forme une zone géographique sur le premier substrat 12. On note les pixels sous la forme générique P(i,j), où i et j sont des entiers naturels désignant respectivement le rang de la ligne et le rang de la colonne dans la matrice 13. L'ensemble des pixels P(i,j) est configuré de façon à générer des signaux en fonction d'un rayonnement frappant le détecteur 10. Le capteur 11 comprend des conducteurs de colonne Yj, chacun reliant les pixels d'une même colonne Cj. Les conducteurs de colonnes Yj sont destinés à transporter les signaux générés par les pixels P(i,j). De même, le capteur 11 comprend des conducteurs de ligne Xi, chacun reliant les pixels d'une même ligne Li. La matrice 13 de pixels P(i,j) comporte des colonnes Cj de rangs pairs et de rangs impairs. De même, la matrice 13 de pixels P(i,j) comporte des lignes Li de rangs pairs et de rangs impairs. Le capteur 10 comprend des plots de contact 14 situé à la périphérie du premier substrat 12 et en dehors de la matrice 13 de pixels P(i,j). Les plots de contact 14 sont reliés aux conducteurs de colonne Yj. Dans le détecteur d'images 10 traditionnel, il y a autant de plots de contacts que de conducteurs de colonne Yj. L'écartement entre deux plots de contact voisins est noté d. Le détecteur d'images 10 comprend un bloc d'adressage de lignes 15 situé à proximité du premier substrat 12 et relié aux conducteurs de lignes Xi. On appelle bloc d'adressage de lignes 15 tout ensemble comportant au moins un bloc d'adressage de lignes. Le bloc 15 peut être intégré au premier substrat 12, comme représenté sur la figure 1b ou intégré à un substrat distinct, comme représenté sur la figure 1a. Le bloc d'adressage de lignes 15 permet d'adresser individuellement chaque ligne de pixels Li. Le détecteur d'images 10 comprend un bloc de lecture de colonnes 16 réalisé sur un second substrat 17 différent du premier substrat 12. Le bloc de lecture de colonnes 16 comprend des points de connexion 18 reliant le bloc de lecture de colonnes 16 aux plots de contact 14. Le bloc de lecture de colonnes 16 permet de lire les signaux générés par les pixels de la ligne sélectionnée par le bloc d'adressage de lignes.

Un pixel P(i,j) comporte une photodiode Dp(i,j) associée à un interrupteur électronique T(i,j). Les photodiodes Dp(i,j) peuvent naturellement être remplacées par tout élément photosensible apte à générer un signal électrique lorsqu'il est soumis à un rayonnement de photons. La structure de pixel représentée sur la figure 1a est volontairement simplifiée et des structures plus complexes peuvent être mises en œuvre dans le cadre de l'invention. On peut par exemple réaliser un pixel à partir d'une configuration à trois transistors. Un premier transistor permet de réinitialiser un potentiel de la cathode de la photodiode, un deuxième transistor fonctionne en suiveur et un troisième transistor remplit le rôle de l'interrupteur électronique. Il permet de sélectionner la ligne Li de pixels P(i,j) pour lesquels on souhaite lire le signal. Alternativement, la fonction d'interrupteur électronique peut être remplie par une diode de commutation.

L'interrupteur T(i,j) formé par un transistor est relié par sa grille Gi au conducteur de ligne Xi de la ligne i, par son drain Dj au conducteur de colonne Yj et par sa source Sij à la cathode de la photodiode Dp(i,j). Les anodes de toutes les photodiodes Dp(i,j) sont reliées à un potentiel commun, par exemple la masse. Le bloc d'adressage de ligne 15 comporte des éléments permettant de générer les signaux à injecter sur les conducteurs de ligne Xi pour piloter l'ouverture et la fermeture des transistors T(i,j). Le bloc de lecture de colonne 16 peut comporter des éléments permettant de traiter les signaux reçus sur les conducteurs de colonne Yj. En particulier, il peut s'agir d'un amplificateur et/ou d'un convertisseur analogique - numérique.

Le capteur d'images 11 fonctionne de la manière suivante. Lors d'une phase de prise d'image, l'exposition des photodiodes Dp(i,j) à un rayonnement génère des charges électriques au niveau de la source Sij. La quantité de charges au niveau de chaque source Sij est fonction de l'intensité du rayonnement reçu par le pixel P(i,j) considéré. La phase de prise d'image est suivie d'une phase de lecture effectuée ligne par ligne. Les signaux injectés sur les différents conducteurs de ligne Xi passent successivement à l'état actif, de sorte que le potentiel de chaque conducteur de colonne Yj est successivement représentatif de la quantité de charges électriques accumulées dans les différents pixels P(i,j) de la colonne j.

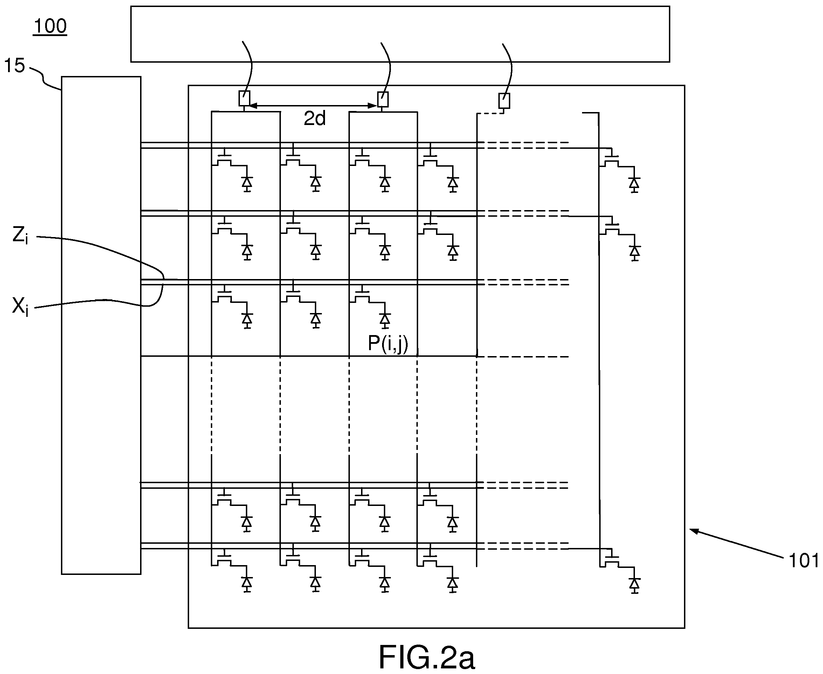

La figure 2a représente une configuration d'un détecteur d'images 100 selon l'invention. Tous les éléments sont identiques au détecteur d'images 10 représenté sur les figures 1a et 1b à l'exception de la connexion des conducteurs de colonne Yj aux plots de contact 14. En effet, selon l'invention, au moins deux conducteurs de colonne Yj sont connectés ensemble sur le premier substrat 12 en dehors de la matrice 13 de pixels P(i,j) et les conducteurs de colonne Yj connectés ensemble convergent vers un même plot de contact 14. On traite ici une configuration où deux conducteurs de colonne sont reliés ensemble. Il est bien entendu possible de connecter plus que deux conducteurs de colonne ensemble et de les faire converger vers un seul plot de contact. L'écartement entre deux plots de contact voisins dans la configuration du détecteur d'images 100 selon l'invention est alors le double de l'écartement entre deux plots de contact voisins dans la configuration traditionnelle du détecteur d'images 10. Autrement dit, l'écartement entre deux plots de contact voisins dans la configuration du détecteur d'images 100 selon l'invention est égale à 2d.

De plus, la configuration du détecteur d'images représenté sur la figure 2a nécessite un double conducteur de lignes par ligne Li de pixels P(i,j). En effet, deux colonnes j et j+1 étant mises en commun au niveau d'un plot de contact 14, le bloc de lecture de colonne 16 traite les signaux reçus au niveau du plot de contact 14. Autrement dit, le bloc de lecture de colonne 16 traite la quantité de charges électriques accumulées dans les différents pixels P(i,j) des deux colonnes j et j+1. Mais on souhaite pouvoir lire la colonne j séparément de la colonne j+1. Ainsi, en plus du conducteur de lignes Xi, on définit par Zi un autre conducteur de ligne. Xi est un conducteur de ligne correspondant aux colonnes de rangs impairs et Zi est un conducteur de lignes correspondant aux colonnes de rangs pairs. Pour lire la quantité de charges électriques accumulées dans les différents pixels P(i,j) de la colonne j, j étant impair, le signal injecté sur le conducteur de ligne Xi passe à l'état actif, de sorte que le potentiel de chaque conducteur de colonne Yj est représentatif de la quantité de charges électriques accumulées dans les différents pixels P(i,j) de la colonne j. De même, pour la colonne (j+1) paire, le signal est injecté sur le conducteur de ligne Zi. Le bloc de lecture de colonne 16 peut traiter la quantité de charges électriques accumulées dans les différents pixels P(i,j) soit de la colonne j, soit de la colonne j+1.

La mise en commun de deux conducteurs de colonne deux par deux sur le premier substrat 12 en dehors de la matrice 13 de pixels P(i,j) et convergeant vers un plot de contact 14 apporte un avantage supplémentaire. Comme la connexion se fait en dehors de la matrice 13, si une colonne Cj de pixels P(i,j) est défectueuse, la colonne voisine mise en commun avec la colonne Cj peut tout de même être lue correctement.

Par contre, la charge capacitive formée par deux conducteurs de colonne connectés entre eux au niveau d'un plot de contact est significativement augmentée puisqu'il s'agit non plus de la charge capacitive d'un seul conducteur de colonne mais de la charge capacitive de deux conducteurs de colonne que l'on peut aussi considérer comme un seul conducteur de colonne mais deux fois plus long et donc avec une capacité plus importante. Or, plus la capacité d'un conducteur de colonne est grande, plus il y a du bruit dans le détecteur d'images, réduisant donc la qualité de l'image.

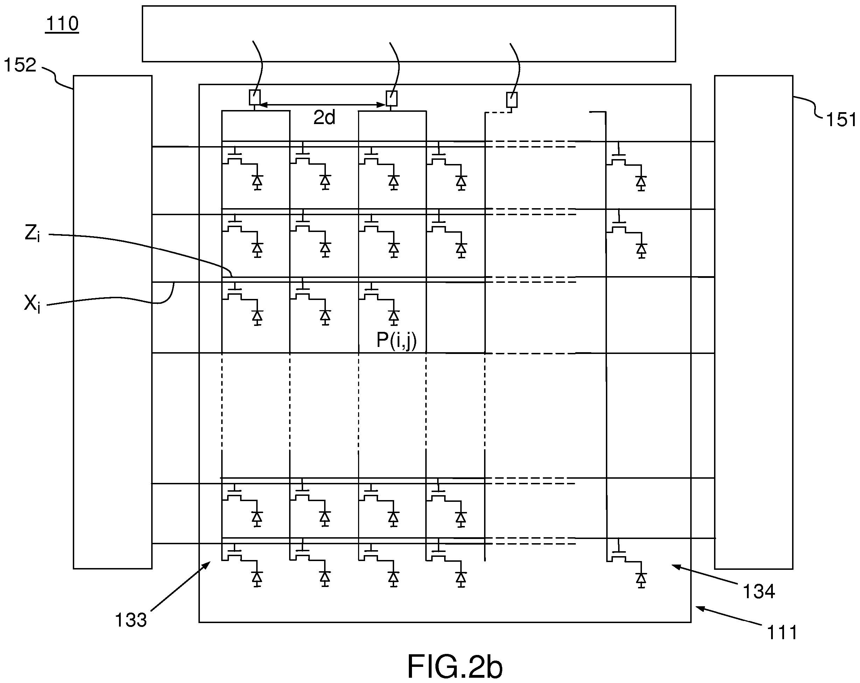

La figure 2b représente un détecteur d'images 110 comprenant un capteur 111 correspondant à la même configuration du détecteur d'images 100 selon l'invention. Un bloc d'adressage de lignes 151 est situé d'un côté 134 de la matrice 13 et un bloc d'adressage de lignes 152 est situé d'un autre côté 133 de la matrice 13. Il est à noter que dans le cas d'une matrice formée de quatre côtés, le bloc d'adressage de lignes 151 est situé d'un côté 134 de la matrice 13 et le bloc d'adressage de lignes 152 est situé d'un autre côté 133 de la matrice, opposé à celui où est situé le bloc d'adressage de lignes 151. Il est également possible d'avoir une matrice possédant plus de quatre côtés, par exemple six côtés pour une matrice hexagonale ou huit côtés pour une matrice octogonale. Dans ce cas, le bloc d'adressage de lignes 152 est situé d'un autre côté de la matrice, pas nécessairement opposé à celui où est situé le bloc d'adressage de lignes 151. Les conducteurs de lignes Xi de lignes de rangs pairs sont reliés au bloc d'adressage de lignes 152 du côté 133 de la matrice 13 et les conducteurs de lignes Zi de lignes de rangs impairs sont reliés au second bloc d'adressage de lignes 151 de l'autre côté 134 de la matrice 13.

Généralement, le détecteur d'images est réalisé en couches minces sur un substrat en verre. Plus précisément, il peut être réalisé en couches minces de silicium amorphe, noté a-Si. Dans la littérature anglo-saxonne, on parle également de TFT pour Thin Film Transistor a-Si. Le détecteur d'images peut également être réalisé en couches minces de poly-silicium, souvent dénommé dans la littérature anglo-saxonne par LTPS pour Low Temperature Poly Silicon. Le détecteur d'images peut aussi être réalisé avec des oxydes métalliques. On peut citer comme exemples les oxydes de zinc IGZO, pour Indium Gallium Zinc Oxyde ou IZO, pour Indium Zinc Oxyde. Enfin le détecteur d'images peut être réalisé avec des matériaux organiques, aussi appelés OTFT pour organic TFT.

Aujourd'hui, les substrats support des technologies en couches minces sont traditionnellement en verre. On peut aussi réaliser un détecteur d'images sur un substrat en polymère.

Il est également possible de réaliser un détecteur d'images en silicium monocristallin du type CMOS (pour Complementary Metal Oxyde Semiconductor) ou BiCMOS (pour Bipolar CMOS). Dans ce cas, le substrat est constitué du même matériau, c'est-à-dire que le substrat est en silicium.

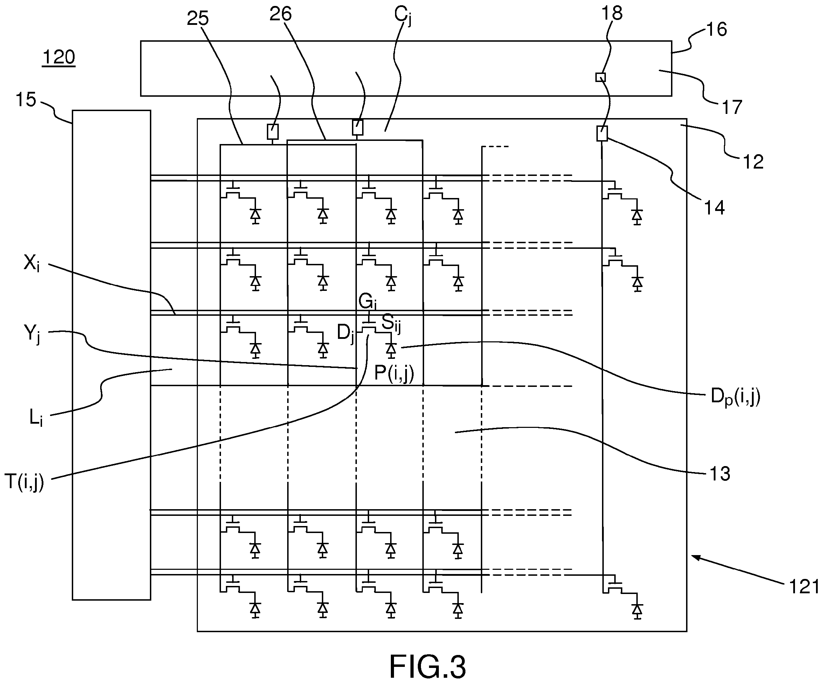

La figure 3 représente une autre configuration d'un détecteur d'images 120 avec un capteur 121 selon un exemple utile à la compréhension de l'invention. Tous les éléments sont identiques au détecteur d'images 100 représenté sur la figure 2a, à l'exception de la connexion des conducteurs de colonnes Yj. Dans la configuration de la figure 3, la connexion entre deux conducteurs de colonne Yj est effectuée entre des conducteurs de colonnes Yj de colonnes Cj non immédiatement voisines entre elles. Autrement dit, on définit un premier groupe 25 de conducteurs connectés et un second groupe 26 de conducteurs connectés. Deux conducteurs de colonnes Yj appartiennent au premier groupe 25 de conducteurs connectés et deux autres conducteurs de colonnes Yj appartiennent au second groupe 26 de conducteurs connectés. Le premier groupe 25 et le second groupe 26 ne sont pas connectés entre eux et le premier groupe 25 et le second groupe 26 sont entrelacés. L'avantage de cette configuration réside dans le fait que si une colonne est défectueuse et qu'aucune réparation n'est effectuée, le défaut d'une colonne n'empêche pas de lire correctement deux colonnes voisines, mais deux colonnes distantes. Sur la figure 3, on connecte deux conducteurs de colonnes ensemble. Il est bien entendu possible de connecter plusieurs autres conducteurs de colonnes.

De même que dans le cas d'un détecteur traditionnel comme illustré sur la figure 1a, la matrice 13 de pixels P(i,j) comporte des colonnes Cj de rangs pairs et de rangs impairs. On peut choisir d'effectuer la connexion entre deux conducteurs de colonne Yj soit avec des conducteurs Yj de colonnes de rangs pairs, soit avec des conducteurs Yj de colonnes de rangs impairs.

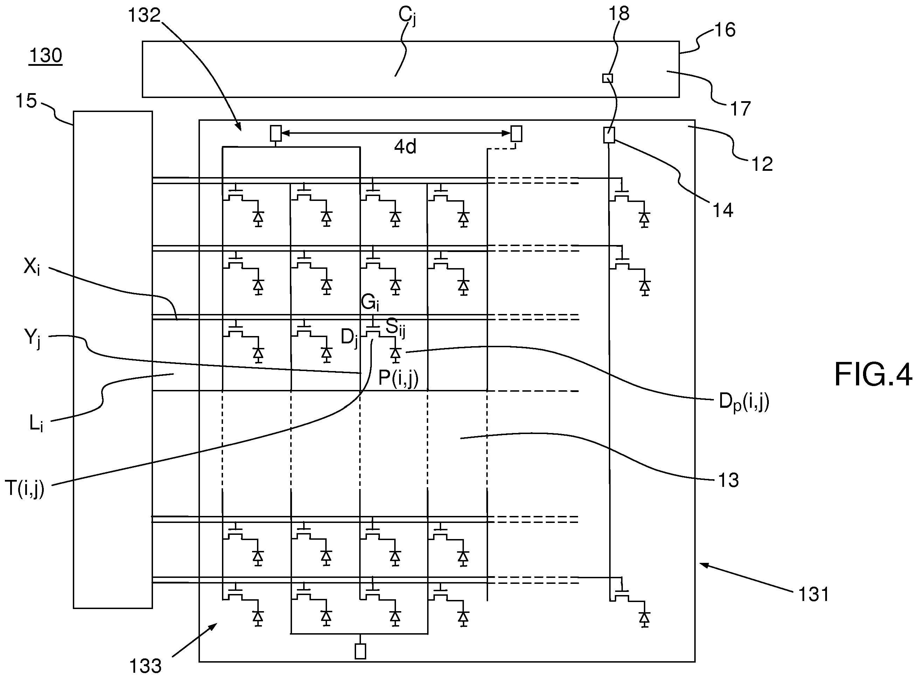

La figure 4 représente une autre configuration d'un détecteur d'images 130 avec un capteur 131 selon un exemple utile à la compréhension de l'invention. Tous les éléments sont identiques au détecteur d'images 120 représenté sur la figure 3, à l'exception du positionnement des plots de contact 14 et de la connexion des conducteurs de colonnes Cj. Sur la figure 4, les plots de contact 14 sont situés d'un premier côté 132 et d'un second côté 133 de la matrice 13. La connexion entre au moins deux conducteurs de colonne Yj se fait alternativement sur le premier côté 132 et sur le second côté 133 de la matrice 13. On peut par exemple connecter sur le premier côté 132 de la matrice 13 des conducteurs Yj de colonnes de rangs pairs ensemble et sur le second côté 133 de la matrice des conducteurs Yj de colonnes de rangs impairs ensemble. Cette configuration présente l'avantage d'augmenter l'écartement entre deux plots de contact du même côté. En effet, deux plots de contact sont espacés de la distance 4d. De plus, la configuration présentée sur la figure 4 réduit le nombre de croisements de conducteurs de colonnes comparé à la configuration présentée sur la figure 3, réduisant ainsi l'augmentation de la charge capacitive due au croisement des conducteurs de colonnes.

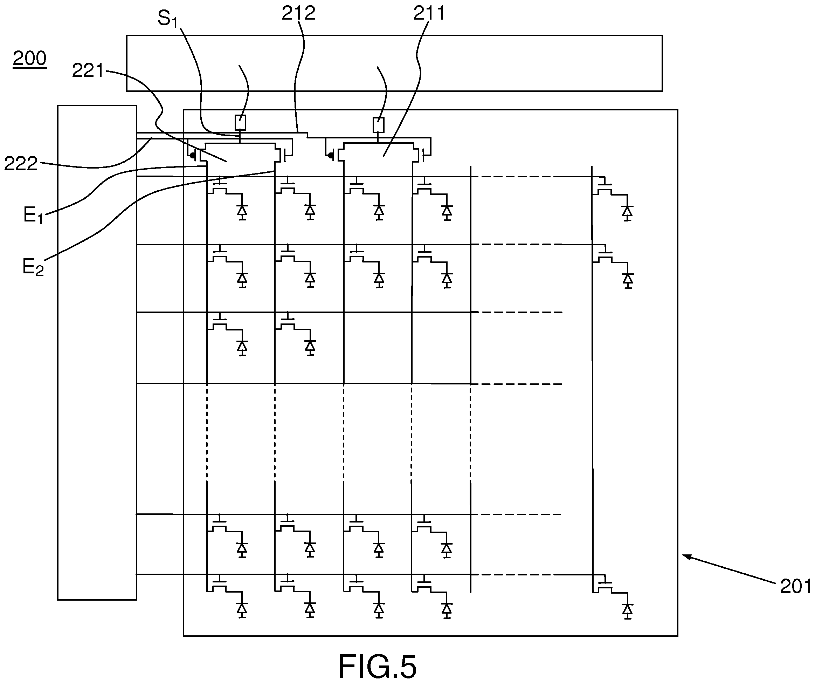

La figure 5 représente une autre configuration d'un détecteur d'images 200 selon un exemple utile à la compréhension de l'invention. Le détecteur d'images 200 comprend un capteur 201. Tous les éléments sont identiques au détecteur d'images 100 représenté sur la figure 2a à l'exception du nombre de conducteurs de lignes et de la connexion des conducteurs de colonne Yj aux plots de contact 14. La configuration représentée sur la figure 5 comporte un multiplexeur pour deux colonnes de pixels. La connexion entre deux conducteurs de colonnes Yj est effectuée au moyen d'un multiplexeur. Sur la figure 5, deux multiplexeurs 211, 221 sont représentés. Un multiplexeur est un circuit permettant de concentrer sur une même voie de transmission plusieurs liaisons en sélectionnant une entrée parmi un certain nombre d'entrées. Les multiplexeurs 211 et 221 sont des multiplexeurs appelés « 2 vers 1 » ou multiplexeurs 1 bit. Un multiplexeur 1 bit permet de sélectionner une entrée parmi 2 entrées disponibles, donnant à la sortie la valeur de l'entrée. Le multiplexeur 221 comporte deux entrées possibles E1 et E2 et une sortie S1. Une ligne de commande 222 indique quelle entrée est choisie. Si l'entrée E1 est choisie, la sortie S1 prendra la valeur de E1. Inversement, si l'entrée E2 est choisie, la sortie S1 prendra la valeur de E2. L'utilisation d'un multiplexeur pour mettre en commun deux colonnes Cj de pixels P(i,j) permet de ne plus avoir un double conducteur de lignes par ligne Li de pixels P(i,j) comme dans la configuration des figures 2a et 2b. Le détecteur d'images 200 comprend une ligne de commande par multiplexeur. Ainsi, la charge capacitive représentée par deux conducteurs de colonne connectés deux par deux n'est pas augmentée comme c'est le cas avec la configuration représentée sur la figure 2a. La mise en commun de deux conducteurs de colonne par multiplexeur permet de réduire le bruit dans le détecteur d'images par rapport à la configuration de la figure 2.

La figure 5 représente la mise en commun de deux conducteurs de colonnes mais, de même que pour les configurations précédentes, il est tout à fait possible d'en connecter plusieurs ensemble.

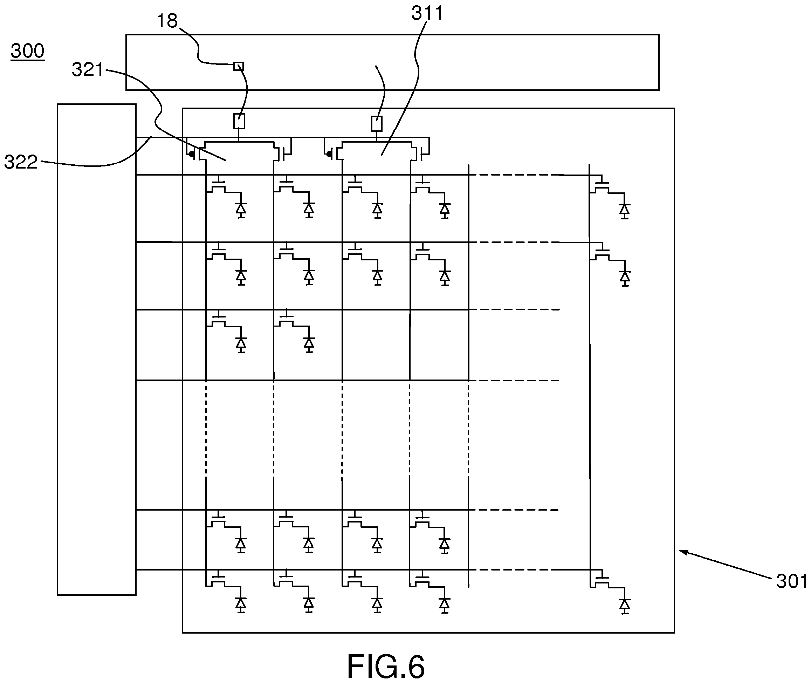

La figure 6 représente une configuration d'un détecteur d'images 300 selon un exemple utile à la compréhension de l'invention. Le détecteur d'images 300 comprend un capteur 301. Tous les éléments sont identiques au détecteur d'images 200 représenté sur la figure 5 à l'exception des lignes de commandes des multiplexeurs. Dans la figure 6, le détecteur 300 comprend une ligne de commande unique pour plusieurs multiplexeurs. Deux multiplexeurs 311 et 321 sont représentés. De même que pour la configuration représentée sur la figure 5, chaque multiplexeur comporte deux entrées, une sortie et une ligne de commande 322. La ligne de commande 322 indique pour chaque multiplexeur 311 et 321 quelle entrée est choisie pour déterminer la valeur de la sortie qui sera traitée par le bloc de lecture de colonne 16. Ainsi, sur chaque plot 18, on obtient soit le signal délivré par un pixel de rang impair dans sa ligne, soit le signal délivré par un pixel de rang pair dans sa ligne, en fonction de la ligne de commande 322.

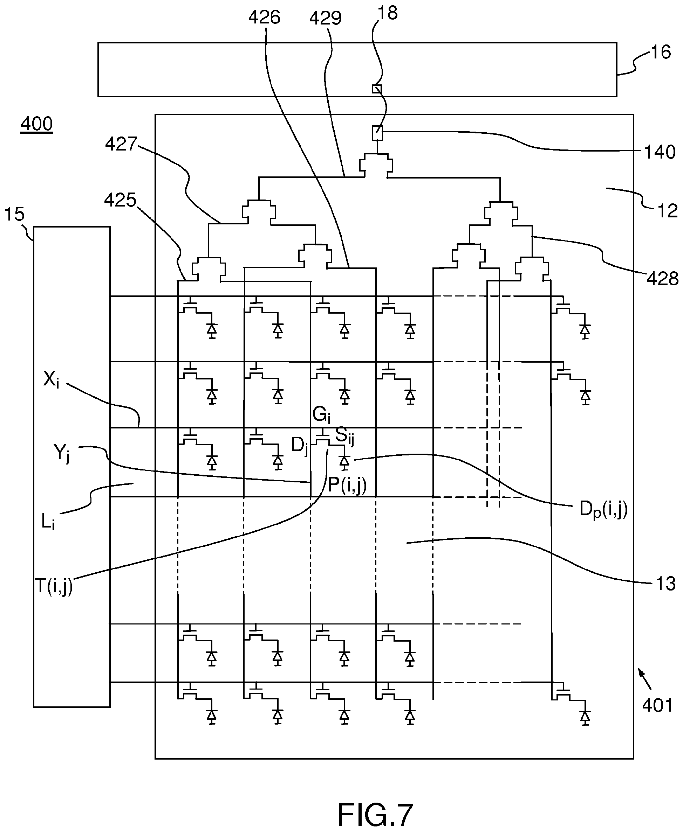

La figure 7 représente une autre variante d'un détecteur d'images 400 selon un exemple utile à la compréhension de l'invention. Le détecteur d'images 400 comprend un capteur 401. Tous les éléments sont identiques au détecteur d'images 200 représenté sur la figure 5 à l'exception de la connexion des multiplexeurs aux plots de contact. Un groupe 425 de conducteurs de colonne connectés est constitué d'au moins deux conducteurs de colonne Yj connectés ensemble. De même, un groupe 426 de conducteurs de colonne connectés est constitué d'au moins deux conducteurs de colonne Yj connectés ensemble. Au moins deux groupes 425, 426 de conducteurs de colonne Yj connectés sont connectés ensemble sur le premier substrat 12 en dehors de la matrice 13 de pixels P(i,j). Les groupes 425 et 426 de conducteurs de colonne Yj connectés ensemble forment un étage de connexion 427 et peuvent converger vers un plot de contact 14. De même, on définit un autre étage de connexion 428. De manière similaire, deux étages de connexion 427 et 428 peuvent être connectés ensemble et former un étage de connexion de niveau supérieur 429. Enfin, il est possible que tous les étages soient connectés entre eux et convergent vers un unique plot de contact 140 d'un côté de la matrice 13. Autrement dit, les conducteurs de colonnes Yj sont connectés entre eux et convergent vers un unique plot de contact 140 d'un côté de la matrice 13 au travers des différents étages de connexion .

Comme représenté sur la figure 7, la connexion entre les conducteurs de colonne, entre les groupes de conducteurs et entre les étages de connexion se fait par des multiplexeurs. Par souci de meilleure lisibilité, les lignes de commandes des multiplexeurs ne sont pas représentées sur la figure 7. Les caractéristiques et commandes des multiplexeurs sont identiques à celles présentées sur la figure 5. De même, il est envisageable d'avoir des connexions simples entre conducteurs de colonne, entre groupes de conducteurs et entre étages de connexion, comme présentées sur la figure 3. Une autre configuration est une configuration à connexions simples comme représentée sur la figure 4, avec des connexions alternativement d'un côté ou d'un autre côté de la matrice de pixels. Enfin, une autre configuration consisterait à avoir des connexions simples et des connexions par multiplexeurs. Ces trois dernières configurations faisant intervenir des connexions simples multiples sont néanmoins difficiles à mettre en œuvre puisque chaque connexion nécessite une ligne de commande supplémentaire.

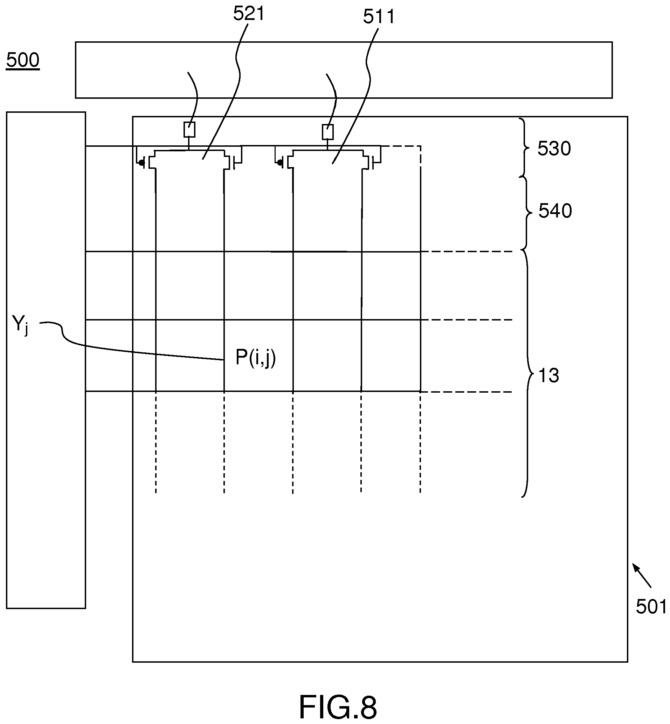

La figure 8 représente un détecteur d'images 500 selon l'invention. Le détecteur d'images 500 comprend un capteur 501 et des moyens de connexion de deux conducteurs de colonne. Sur la figure 8, deux multiplexeurs 511 et 521 sont représentés. Il est bien entendu qu'il pourrait s'agir également d'une simple connexion comme représentée sur la figure 2a. Le capteur 501 comprend la matrice 13 de pixels, une zone 530 de connexion des conducteurs de colonne Yj distincte de la matrice 13 et une zone 540 dédiée à la réparation des conducteurs de colonne Yj distincte de la matrice 13 et de la zone 530 de connexion des conducteurs de colonne Yj. La zone 540 dédiée à la réparation des conducteurs de colonne Yj se situe entre la matrice 13 et la zone 530 de connexion des conducteurs de colonne Yj. La zone 540 de réparation permet notamment d'effectuer une réparation par laser. En cas de défaut d'une colonne de pixels, il peut être souhaité d'isoler la colonne défectueuse. Cette isolation peut être effectuée à l'aide d'un faisceau laser qui est envoyé sur le conducteur de colonne de la colonne défectueuse dans la zone 540 de réparation. Le conducteur de colonne peut être une piste en métal. Sous l'effet du faisceau laser, le métal s'évapore. La piste est alors coupée et la colonne défectueuse est isolée.

## Revendications

1. Détecteur d'images (100 ; 110 ; 120 ; 130 ; 200 ; 300 ; 400 ; 500) comprenant :
• un capteur (101 ; 111 ; 121 ; 131 ; 201 ; 301 ; 401 ; 501) réalisé sur un premier substrat monolithique (12) comprenant :
∘ un ensemble de pixels (P(i,j)) organisé en matrice (13) selon des lignes (Li) et des colonnes (Cj) et configuré de façon à générer des signaux en fonction d'un rayonnement frappant le détecteur (100 ; 200 ; 300 ; 400),
∘ des conducteurs de colonne (Yj), chacun reliant les pixels (Pi,j) d'une même colonne (Cj) et destinés à transporter les signaux générés par les pixels,
∘ au moins un plot de contact (14, 140) situé à la périphérie du premier substrat (12) et en dehors de la matrice (13) de pixels (P(i,j)) et relié aux conducteurs de colonne (Cj),
∘ au moins deux conducteurs de colonne (Yj) connectés ensemble sur le premier substrat (12) en dehors de la matrice (13) de pixels (P(i,j)) et les conducteurs de colonne (Yj) connectés ensemble convergent vers le au moins un plot de contact (14, 140), et le détecteur d'images (100 ; 110, 120 ; 130 ; 200 ; 300 ; 400 ; 500) comprend des conducteurs de lignes (Xi), chacun reliant les pixels (P(i,j)) d'une même ligne (Li), et un bloc d'adressage de lignes (15) et relié aux conducteurs de lignes (Xi),
**caractérisé en ce que** le détecteur d'images (100 ; 110, 120 ; 130 ; 200 ; 300 ; 400 ; 500) comprend en outre au moins un conducteur de lignes additionnel (Zi) par ligne (Li), **en ce que** les conducteurs de lignes (Xi) sont connectés aux colonnes de rang impair, **en ce que** le au moins un conducteur de lignes additionnel (Zi) est connecté aux colonnes de rang pair, permettant de lire individuellement chaque pixel (P(i,j)).

2. Détecteur d'images (130) selon la revendication 1, **caractérisé en ce que** le capteur comprend plusieurs plots de contact (14), **en ce que** les plots de contact (14) sont situés d'un premier côté (132) et d'un second côté (133) de la matrice (13) et **en ce que** la connexion entre au moins deux conducteurs de colonne (Yj) se fait alternativement sur le premier côté (132) et sur le second côté (133) de la matrice (13).

3. Détecteur d'images (100 ; 110 ; 120 ; 130 ; 200 ; 300 ; 400 ; 500) selon l'une des revendications 1 ou 2, **caractérisé en ce que** le bloc d'adressage de lignes (15) est intégré au premier substrat (12).

4. Détecteur d'images (100 ; 110 ; 120 ; 130 ; 200 ; 300 ; 400 ; 500) selon la revendication 3, **caractérisé en ce qu'**il comprend plusieurs blocs et **en ce qu'**un premier des blocs d'adressage de lignes (151) est situé d'un côté (133) de la matrice (13) et un second des blocs d'adressage de lignes (152) est situé d'un autre côté (134) de la matrice (13).

5. Détecteur d'images (100 ; 110 ; 120 ; 130 ; 200 ; 300 ; 400 ; 500) selon la revendication 4, **caractérisé en ce que** la matrice (13) comporte des lignes (Li) de rangs pairs et de rangs impairs, et **en ce que** les conducteurs de lignes (Xi) de lignes de rangs pairs sont reliés au premier bloc d'adressage de lignes (15) d'un côté de la matrice (13) et les conducteurs de lignes (Xi) de lignes de rangs impairs sont reliés au second bloc d'adressage de lignes (15) d'un autre côté de la matrice (13).

6. Détecteur d'images (200 ; 300 ; 400 ; 500) selon l'une des revendications précédentes, **caractérisé en ce que** la connexion entre au moins deux conducteurs de colonne (Yj) est effectuée au moyen d'un multiplexeur (211, 221 ; 311, 321, 511, 521).

7. Détecteur d'images (200 ; 400) selon la revendication 6, **caractérisé en ce qu'**il comprend une ligne de commande (212, 222) par multiplexeur.

8. Détecteur d'images (300 ; 400 ; 500) selon la revendication 7, **caractérisé en ce qu'**il comprend une ligne de commande (322) commune à plusieurs multiplexeurs.

9. Détecteur d'images (400) selon l'une des revendications précédentes, **caractérisé en ce que** un groupe de conducteurs de colonne connectés est constitué d'au moins deux conducteurs de colonne (Yj) connectés ensemble et **en ce que** au moins deux groupes (425, 426) de conducteurs de colonne (Yj) connectés sont connectés ensemble sur le premier substrat (12) en dehors de la matrice (13) de pixels (P(i,j)) et au moins deux groupes (425, 426) de conducteurs de colonne (Yj) connectés ensemble forment un étage de connexion (427, 428) et convergent vers un plot de contact (14, 140).

10. Détecteur d'images (400) selon la revendication 9, **caractérisé en ce que** les conducteurs de colonne (Yj) sont connectés entre eux et convergent vers un unique plot de contact (140) d'un côté de la matrice (13) au travers des différents étages de connexion (427, 428).

11. Détecteur d'images (500) selon l'une des revendications précédentes, **caractérisé en ce que** le capteur (501) comprend la matrice (13) de pixels, une zone (530) de connexion des conducteurs de colonne (Yj) distincte de la matrice (13) et une zone (540) dédiée à la réparation des conducteurs de colonne (Yj) distincte de la matrice (13) et de la zone (530) de connexion des conducteurs de colonne (Yj), et **en ce que** la zone (540) dédiée à la réparation des conducteurs de colonne (Yj) se situe entre la matrice (13) et la zone (530) de connexion des conducteurs de colonne (Yj).

12. Détecteur d'images (100 ; 110 ; 120 ; 130 ; 200 ; 300 ; 400 ; 500) selon l'une des revendications précédentes, **caractérisé en ce qu'**il comprend un bloc de lecture de colonnes (16) réalisé sur un second substrat (17) différent du premier substrat (12) et relié à le au moins un plot de contact (14, 140), permettant de lire les signaux générés par les pixels (P(i,j)).

## Patentansprüche

1. Bilddetektor (100; 110; 120; 130; 200; 300; 400; 500), Folgendes beinhaltend:
• einen Sensor (101; 111; 121; 131; 201; 301; 401; 501), welcher auf einem ersten monolithischen Substrat (12) hergestellt ist, Folgendes beinhaltend:
∘ eine Gruppe von zu einer Matrix (13) nach Zeilen (Li) und Spalten (Cj) organisierten Pixeln (P(i,j)), welche konfiguriert ist, um Signale angesichts einer auf den Sensor (100; 200; 300; 400) auftreffenden Strahlung zu erzeugen,
∘ Spaltenleiter (Yj), welche jeweils die Pixel (Pi,j) einer selben Spalte (Cj) verbinden und dazu bestimmt sind, die durch die Pixel erzeugten Signale zu transportieren,
∘ mindestens einen Kontakthöcker (14, 140), welcher an der Peripherie des ersten Substrates (12) und außerhalb der Matrix (13) aus Pixeln (P(i,j)) befindlich und mit den Spaltenleitern (Cj) verbunden ist,
∘ mindestens zwei Spaltenleiter (Yj), welche gemeinsam auf dem ersten Substrat (12) außerhalb der Matrix (13) von Pixeln (P(i,j)) verbunden sind, und wobei die gemeinsam verbundenen Spaltenleiter (Yj) in Richtung des mindestens einen Kontakthöckers (14, 140) konvergieren, und wobei der Bilddetektor (100; 110, 120; 130; 200; 300; 400; 500) Zeilenleiter (Xi) beinhaltet, welche jeweils die Pixel (P(i,j)) einer selben Zeile (Li) verbinden, und einen Zeilenadressierungsblock (15), welcher mit den Zeilenleitern (Xi) verbunden ist,
**dadurch gekennzeichnet, dass** der Bilddetektor (100; 110, 120; 130; 200; 300; 400; 500) zudem mindestens einen zusätzlichen Zeilenleiter (Zi) pro Zeile (Li) beinhaltet, und dadurch, dass die Zeilenleiter (Xi) mit den Spalten ungleichzahligen Ranges verbunden sind, und dadurch, dass der mindestens eine zusätzliche Zeilenleiter (Zi) mit den Spalten geradzahligen Ranges verbunden ist, wodurch die Möglichkeit besteht, jeden Pixel (P(i,j)) einzeln zu lesen.

2. Bilddetektor (130) nach Anspruch 1, **dadurch gekennzeichnet, dass** der Sensor mehrere Kontakthöcker (14) beinhaltet, dadurch, dass die Kontakthöcker (14) auf einer ersten Seite (132) und einer zweiten Seite (133) der Matrix (13) befindlich sind und dadurch, dass die Verbindung zwischen mindestens zwei Spaltenleitern (Yj) abwechselnd auf der ersten Seite (132) und der zweiten Seite (133) der Matrix (13) erfolgt.

3. Bilddetektor (100; 110; 120; 130; 200; 300; 400; 500) nach einem der Ansprüche 1 oder 2, **dadurch gekennzeichnet, dass** der Zeilenadressierungsblock (15) in das erste Substrat (12) integriert ist.

4. Bilddetektor (100; 110; 120; 130; 200; 300; 400; 500) nach Anspruch 3, **dadurch gekennzeichnet, dass** er mehrere Blöcke beinhaltet und dass ein erster Zeilenadressierungsblock (151) auf einer Seite (133) der Matrix (13) befindlich ist, und ein zweiter Zeilenadressierungsblock (152) auf einer anderen Seite (134) der Matrix (13) befindlich ist.

5. Bilddetektor (100; 110; 120; 130; 200; 300; 400; 500) nach Anspruch 4, **dadurch gekennzeichnet, dass** die Matrix (13) Zeilen (Li) geradzahliger und ungeradzahliger Ränge beinhaltet, und dadurch, dass die Zeilenleiter (Xi) von Zeilen geradzahliger Ränge mit dem ersten Zeilenadressierungsblock (15) auf einer Seite der Matrix (13) verbunden sind und die Zeilenleiter (Xi) von Zeilen ungeradzahliger Ränge mit dem zweiten Zeilenadressierungsblock (15) auf einer anderen Seite der Matrix (13) verbunden sind.

6. Bilddetektor (200; 300; 400; 500) nach einem der vorhergehenden Ansprüche, **dadurch gekennzeichnet, dass** die Verbindung zwischen mindestens zwei Spaltenleitern (Yj) mithilfe eines Multiplexers (211, 221; 311, 321, 511, 521) erfolgt.

7. Bilddetektor (200; 400) nach Anspruch 6, **dadurch gekennzeichnet, dass** er eine Steuerleitung (212, 222) pro Multiplexer beinhaltet.

8. Bilddetektor (300; 400, 500) nach Anspruch 7, **dadurch gekennzeichnet, dass** er eine gemeinsame Steuerleitung (322) für mehrere Multiplexer beinhaltet.

9. Bilddetektor (400) nach einem der vorhergehenden Ansprüche, **dadurch gekennzeichnet, dass** eine Gruppe von verbundenen Spaltenleitern aus mindestens zwei gemeinsam verbundenen Spaltenleitern (Yj) besteht und dadurch, dass mindestens zwei Gruppen (425, 426) von verbundenen Spaltenleitern (Yj) gemeinsam an einem ersten Substrat (12) außerhalb der Matrix (13) von Pixeln (P(i,j)) verbunden sind und mindestens zwei Gruppen (425, 426) von gemeinsam verbundenen Spaltenleitern (Yj) eine Verbindungsstufe (427, 428) bilden und in Richtung eines Kontakthöckers (14, 140) konvergieren.

10. Bilddetektor (400) nach Anspruch 9, **dadurch gekennzeichnet, dass** die Spaltenleiter (Yj) miteinander verbunden sind und in Richtung eines einzigen Kontakthöckers (140) auf einer Seite der Matrix (13) über unterschiedliche Verbindungsstufen (427, 428) konvergieren.

11. Bilddetektor (500) nach einem der vorhergehenden Ansprüche, **dadurch gekennzeichnet, dass** der Sensor (501) die Pixelmatrix (13), einen Verbindungsbereich (530) der Spaltenleiter (Yj), welcher sich von der Matrix (13) unterscheidet und einen Bereich (540) für die Reparatur der Spaltenleiter (Yj), welcher sich von der Matrix (13) und dem Verbindungsbereich (530) der Spaltenleiter (Yj) unterscheidet, beinhaltet, und dadurch, dass der Bereich (540) für die Reparatur der Spaltenleiter (Yj) sich zwischen der Matrix (13) und dem Verbindungsbereich (530) der Spaltenleiter (Yj) befindet.

12. Bilddetektor (100; 110; 120; 130; 200; 300; 400; 500) nach einem der vorhergehenden Ansprüche, **dadurch gekennzeichnet, dass** er einen Spaltenleseblock (16) beinhaltet, welcher an einem zweiten Substrat (17), welches sich vom ersten Substrat (12) unterscheidet, hergestellt ist, und mit dem mindestens einen Kontakthöcker (14, 140) verbunden ist, wodurch die Möglichkeit besteht, die durch die Pixel (P(i,j)) erzeugten Signale zu lesen.

## Claims

1. An image detector (100; 110; 120; 130; 200; 300; 400; 500) comprising:
• a sensor (101; 111; 121; 131; 201; 301; 401; 501) produced on a first monolithic substrate (12) comprising:
∘ a set of pixels (P(i,j)) organized in a matrix (13) in rows (Li) and columns (Cj) and configured so as to generate signals as a function of a radiation striking the detector (100; 200; 300; 400),
∘ column conductors (Yj), each linking the pixels (Pi,j) of a same column (Cj) and intended to convey the signals generated by the pixels,
∘ at least one bump contact (14, 140) situated at the periphery of the first substrate (12) and outside of the matrix (13) of pixels (P(i,j)) and linked to the column conductors (Cj),
∘ at least two column conductors (Yj) connected together on the first substrate (12) outside of the matrix (13) of pixels (P(i,j)) and the column conductors (Yj) connected together converge toward the at least one bump contact (14, 140), and the image detector (100; 110, 120; 130; 200; 300; 400; 500) comprises row conductors (Xi), each linking the pixels (P(i,j)) of a same row (Li), and a row addressing block (15) linked to the row conductors (Xi),
**characterized in that** the image detector (100; 110, 120; 130; 200; 300; 400; 500) further comprises at least one row conductor (Zi) per row (Li), **in that** the row conductors (Xi) are connected to the columns of odd ranks, **in that** the at least one further row conductor (Zi) is connected to the columns of even ranks making it possible to individually read each pixel (P(i,j)).

2. The image detector (130) according to claim 1, **characterized in that** the sensor comprises several bump contacts (14), **in that** the bump contact (14) are situated on a first side (132) and on a second side (133) of the matrix (13) and **in that** the connection between at least two column conductors (Yj) is made alternately on the first side (132) and on the second side (133) of the matrix (13).

3. The image detector (100; 110; 120; 130; 200; 300; 400; 500) according to one of claim 1 or 2, **characterized in that** the row addressing block (15) is incorporated in the first substrate (12).

4. The image detector (100; 110; 120; 130; 200; 300; 400; 500) according to claim 3, **characterized in that** it comprises several blocks and **in that** a first of the row addressing blocks (151) is situated on one side (133) of the matrix (13) and a second of the row addressing blocks (152) is situated on another side (134) of the matrix (13).

5. The image detector (100; 110; 120; 130; 200; 300; 400; 500) according to claim 4, **characterized in that** the matrix (13) comprises rows (Li) of even ranks and of odd ranks, and **in that** the row conductors (Xi) of rows of even ranks are linked to the first row addressing block (15) on one side of the matrix (13) and the row conductors (Xi) of rows of odd ranks are linked to the second row addressing block (15) on another side of the matrix (13).

6. The image detector (200; 300; 400; 500) according to one of the preceding claims, **characterized in that** the connection between at least two column conductors (Yj) is made by means of a multiplexer (211, 221; 311, 321, 511, 521).

7. The image detector (200; 400) according to claim 6, **characterized in that** it comprises a command line (212, 222) per multiplexer.

8. The image detector (300; 400; 500) according to claim 7, **characterized in that** it comprises a command line (322) common to several multiplexers.

9. The image detector (400) according to one of the preceding claims, **characterized in that** a group of connected column conductors consists of at least two column conductors (Yj) connected together and **in that** at least two groups (425, 426) of connected column conductors (Yj) are connected together on the first substrate (12) outside of the matrix (13) of pixels (P(i,j)) and at least two groups (425, 426) of column conductors (Yj) connected together form a connection stage (427, 428) and converge toward a bump contact (14, 140).

10. The image detector (400) according to claim 9, **characterized in that** the column conductors (Yj) are connected together and converge toward a single bump contact (140) on one side of the matrix (13) through the different connection stages (427, 428).

11. The image detector (500) according to one of the preceding claims, **characterized in that** the sensor (501) comprises the matrix (13) of pixels, a zone (530) of connection of the column conductors (Yj) distinct from the matrix (13) and a zone (540) dedicated to the repairing of the column conductors (Yj) distinct from the matrix (13) and the zone (530) of connection of the column conductors (Yj), and **in that** the zone (540) dedicated to the repairing of the column conductors (Yj) is situated between the matrix (13) and the zone (530) of connection of the column conductors (Yj).

12. The image detector (100; 110; 120; 130; 200; 300; 400; 500) according to one of the preceding claims, **characterized in that** it comprises a column reading block (16) produced on a second substrate (17) different from the first substrate (12) and linked to the at least one bump contact (14, 140), making it possible to read the signals generated by the pixels (P(i,j)).
